# EUROPEAN PATENT APPLICATION

(11) **EP 4 071 886 A1**
(43) Date of publication of application: **12.10.2022**
(21) Application number: 21167518.6
(22) Date of filing: 08.04.2021
(51) Int. Cl.: H01M 10/48, G01S 5/02, H01M 10/42, G01R 31/396

(54) **BATTERY CELL POSITION DETERMINATION**

(71) Applicant: Dukosi Limited, Edinburgh, EH14 4AP (GB)
(72) Inventor: Jones, Adrian, Edinburgh, EH14 4AP (GB); Sylvester, Joel, Edinburgh, EH14 4AP (GB); Crymble, Tim, Edinburgh, EH14 4AP (GB); Leworthy, Josh, Edinburgh, EH14 4AP (GB); Ballany, Ross, Edinburgh, EH14 4AP (GB)
(74) Representative: Finnegan Europe LLP

(57) **Abstract**

Methods and systems for determining a position of a battery cell within a battery system comprising a plurality of battery cells are disclosed. Each battery cell has a unique identifier, and each battery cell is configured to experience a change in voltage when an electrical stimulus is applied to the battery cell. The method comprises receiving a first signal associated with a first battery cell experiencing a change in voltage due to an electrical stimulus applied to the battery cell; obtaining the unique ID associated with the first battery cell; determining the position of the first battery cell, based on the received first signal associated with the first battery cell; and associating the determined position with the obtained unique ID of the first battery cell.

## Description

### Technical Field

The present disclosure relates to the field of battery technology and energy cells and discloses solutions for determining a position of a battery cell within a battery system comprising a plurality of battery cells. In particular, embodiments of the disclosure relate to a method and a system for determining a position of a battery cell within a battery system comprising a plurality of battery cells.

### Background

Battery systems, comprising a plurality of battery cells, are used in a wide range of modern electric power applications. For example, they are used to power electric vehicles, they are used in industrial power applications, in transportation, and in commercial applications such as powering of modern electronic devices. Given the relatively high-power demands of such applications, a battery system often comprises a plurality of battery cells coupled together to achieve the required power output. The battery cells may be coupled together to form a battery pack, and the battery system may comprise one or more battery packs.

It is common to connect a battery system to a battery management system (BMS), configured to ensure that the battery system operates within its safe operating area. The safe operating area is defined as the voltage and current conditions under which the battery system is expected to operate without self-damage. For further details, the interested reader is directed to the following Wikipedia website: https://en.wikipedia.ora/wiki/Battery management system.

In certain known applications, performance characteristics of the battery cells within the battery system may be monitored, to identify potentially faulty operation of cells within the battery system before a catastrophic fault occurs. The severity of the potential fault may be dependent on the position of the associated cell within the battery system. This is particularly true where the fault is associated with overheating, or a leak of battery fluids or gas. Depending on the position of the cell within the battery system, the fault may potentially provoke a catastrophic chain reaction. For example, an overheating cell located centrally within a battery system, in contact with adjacent cells on all its surfaces, poses a greater risk of causing a chain reaction, than an overheating cell located near a corner of the battery system in physical contact with a single cell. It is therefore important to know the relative positions of the battery cells comprised within a battery system.

As a safety precaution, since it is not always known how to determine the position of individual cells in a battery system, and the position of a faulty cell, it is common to replace the entire battery system, when a fault is identified in a battery cell within the battery system. This often also results in some individual cells within the battery system, which are otherwise functional, and operating normally, to be discarded. This results in significant waste of functional cells, due to the inability to determine the locations of individual cells within the battery system.

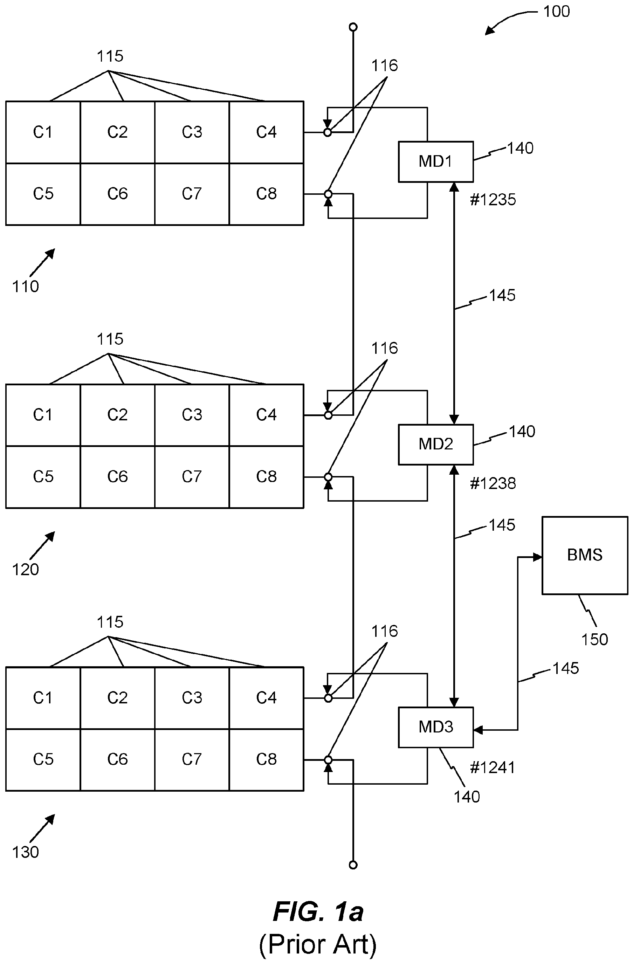

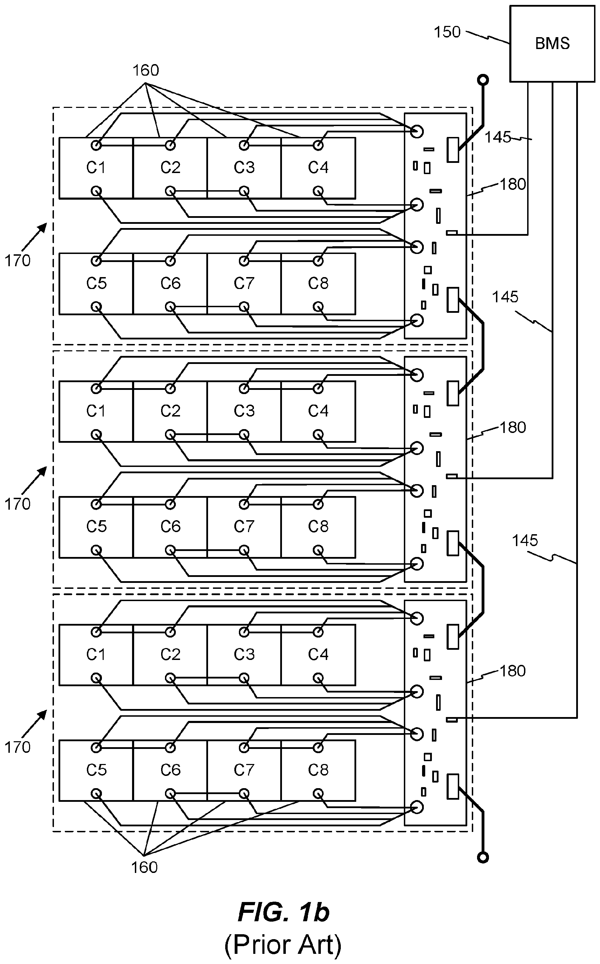

Fig. 1a is a schematic illustration of a known prior art battery system 100, comprising a plurality of battery packs 110, 120, 130. Each pack comprises a plurality of battery cells 115. The cells 115 within each battery pack 110, 120, 130 are commonly connected in series, and each battery pack 110, 120, 130 comprises terminals 116, enabling electrical power to be drawn from the battery pack. In Fig. 1a battery packs 110, 120, 130 are connected to each other in series. Each battery pack 110, 120, 130 may comprise a measuring device (MD) 140, configured to measure performance characteristics of the associated battery pack 110, 120, 130. MD 140 may be arranged to be powered by its respective battery pack 110, 120, 130. In Fig. 1, designations MD1, MD2, and MD3 are used to distinguish between measurement devices 140 coupled to each battery pack 110, 120, 130, and are coupled in series (daisy chained) forming communication channel 145 terminating at battery management system (BMS) 150.

In the prior art systems of Fig. 1a, the problem of identifying the origin of measurement data received by the BMS 150, can be solved based on the hierarchical relationship between nodes present on shared communication channel 145 with BMS 150. To illustrate this, consider an example where BMS 150 is operatively connected to MD3 via shared communication channel 145, as illustrated. To determine the hierarchical configuration of MDs 140, BMS 150 queries the unique ID of the measurement device 140 that is directly connected to it - namely, MD3. MD3 responds to BMS 150 providing its unique ID #1241. BMS 150 now knows the unique ID of MD3 that is directly connected to it. BMS 150 may subsequently ask MD3 to obtain the unique ID of the next measurement device 140 directly connected to MD3 - namely, the unique ID of MD2. MD2 responds to MD3's request by providing its unique ID #1238 to MD3, which is subsequently forwarded to BMS 150. BMS 150 now knows the unique ID of MD2, and knows that MD2 is operatively connected in series to MD3. BMS 150 may subsequently query MD2, via MD3, for the unique ID of any measurement device 140 that is connected in series to MD2. In a similar way as was done by MD3, MD2 queries MD1 for its unique ID, #1235, which is forwarded to BMS 150. In this way BMS 150 is able to determine the communication hierarchy of all measurement devices 140 connected in series within battery system 100, which is defined by the order in which they are physically connected to BMS 150. BMS 150 is able to communicate with any one of MDs 140 within battery system 100 using the associated MDs unique ID. It is to be appreciated that each MD 140 occupies a different level in the communication hierarchy. Each MD 140 is only able to communicate directly with its adjacent MDs 140, except where the subject MD 140 is adjacent to BMS 150. For a given MD 140, for example MD1, communication with BMS 150 requires using the intervening MDs 140 lying along communication channel 145 between MD1 and BMS 150 as proxies.

A shortcoming of the prior art system of Fig. 1a is that it does not enable BMS 150 or MD 140 to determine the position of individual battery cells 115 within a battery pack 110, 120, 130. In particular, neither BMS 150 or MD 140 is able to associate battery cell data received from specific battery cells 115, with the position of the specific battery cell. For example, for a given battery pack 110, it is not possible for MD1 to determine the position of battery cell C7. Thus, once a potential fault is identified with a battery cell within a battery pack from received measurement data, the entire battery associated with the faulty battery cell is still replaced in its entirety.

Fig. 1b illustrates another known prior art system, in which each battery cell 160 within battery pack 170, is hardwired to MD 180. The position of each cell C1-C12 within battery pack 170 may be mapped during assembly of battery pack 170. In use, MD 180 receives measurement data from each one of cells C1-C12, and can determine the source of the received measurement data based on the pre-defined cell mapping information. MDs 180 illustrated in Fig. 1b may be connected in series in a similar manner as described in relation to the prior art system of Fig, 1a. Alternatively, each MD 180 may be directly connected to BMS via a direct wired connection. Such configurations are advantageous since there is no communication hierarchy imposed on BMS 150, and instead communication with each MD 180 is by direct wired connection without use of any proxies. During battery pack assembly, the position of each pack 170, each battery cell C1-C12 within the pack, and its associated measurement device 180 may be mapped and stored for subsequent use. The position of a cell associated with received measurement data may be determined using the predefined position mapping data. A shortcoming of the prior art system of Fig. 1b is that it requires mapping battery cell location information during pack assembly, which increases manufacturing time and associated costs.

It is an object of at least some embodiments of the present disclosure to address one or more shortcomings of the prior art systems, and to provide an improved solution for determining the position of individual battery cells within battery packs and systems. At least some of the disclosed embodiments may be deployed in use to identify the locations of potentially faulty cells for servicing and/or replacement, and/or to complement battery cell diagnostics.

### Summary

In accordance with an aspect of the disclosure there is provided a method of determining a position of a battery cell within a battery system comprising a plurality of battery cells. Each battery cell has a unique identifier (ID), and each battery cell may be configured to experience a change in voltage when an electrical stimulus is applied to the battery cell. The method may comprise: receiving a first signal associated with a first battery cell experiencing a change in voltage due to an electrical stimulus applied to the battery cell; obtaining the unique ID associated with the first battery cell; determining the position of the first battery cell, based on the received first signal associated with the first battery cell; and associating the determined position with the obtained unique ID of the first battery cell.

In accordance with some embodiments each battery cell comprised within the battery system comprises an electrical stimulus, the electrical stimulus having an active state in which the electrical stimulus causes a change in the voltage of the associated battery cell it is connected to.

The method may further comprise receiving the first signal from a voltage measurement device connected to the first battery cell when the associated electrical stimulus is in the active state. In some embodiments the voltage measurement device may be located external to the battery system and may be configured to change the battery cell it is connected to by varying its position relative to the battery system, and the method may further comprise the steps of: determining if the battery cell the voltage measurement device is connected to is experiencing a change in voltage; changing the battery cell the voltage measurement device is connected to if no change in voltage is determined, by varying the position of the voltage measurement device relative to the battery system; and iteratively repeating the determining and changing steps until the voltage measurement device measures the change in voltage experiences by the first battery cell when connected to the first battery cell.

In accordance with some embodiments, each battery cell comprised within the battery system comprises a voltage measurement device, the voltage measurement device configured to measure a change in voltage experienced by the associated battery cell when a stimulus is applied to the battery cell by an electrical stimulus device connected to the associated battery cell. The method may comprise: receiving, from the electrical stimulus device when connected to the first battery cell, the first signal comprising first position information associated with the position of the electrical stimulus device connected to the first battery cell, the first position information comprising information associated with a position of the electrical stimulus device relative to the first battery cell; and determining the position of the first battery cell within the battery system, based on the first position information. The electrical stimulus device may be located external to the battery system and may be configured to change its position relative to the plurality of battery cells in order to connect to a different one of the battery cells, and cause a change in voltage in the connected battery cell.

In accordance with some embodiments, the electrical stimulus may comprise an electrical load having an active state in which the electrical load draws current from the associated battery cell it is connected to, and an inactive state in which current is not drawn from the associated battery cell.

In accordance with some embodiments, the electrical stimulus may comprise a charger having an active state in which the charger charges the associated battery cell it is connected to.

In accordance with another aspect of the disclosure, a processor for determining a position of a battery cell within a battery system comprising a plurality of battery cells, each battery cell having a unique ID, and each battery cell configured to experience a change in voltage when an electrical load is applied to the battery cell. The processor may be configured to: receive a first signal associated with a first battery cell experiencing a change in voltage due to an electrical load applied to the battery cell; obtain the unique ID associated with the first battery cell; determine the position of the first battery cell, based on the received first signal associated with the first battery cell; and associate the determined position with the obtained unique ID of the first battery cell.

In accordance with another aspect of the disclosure there is provided a method of determining a position of a battery cell within a battery system comprising a plurality of battery cells, each battery cell having a unique ID, and each battery cell comprising a processing device configured to emit an activation signal, the battery system being assembled in accordance with a predefined assembly sequence. The method may comprise: receiving an activation signal associated with each one of the plurality of battery cells comprised within the battery system, each activation signal enabling the unique ID of the associated battery cell to be obtained; associating a time coordinate with each received activation signal; determining an activation sequence defining an order in which the processing devices associated with the plurality of battery cells are activated based on the time coordinate associated with each received activation signal and the unique ID associated with each battery cell; and determining the position of each battery cell based on the activation sequence and the predefined assembly sequence. The predefined assembly sequence may define the physical order in which the plurality of battery cells are positioned within the battery system, and the method may further comprise determining the position of each battery cell by associating the activation sequence with the physical order in which the plurality of battery cells are positioned within the battery system. The predefined assembly sequence may define the physical order in which the plurality of battery cells are positioned within the battery system.

In accordance with some embodiments, the activation signal may be emitted when the processing device first activates during assembly of the battery system, and the method may further comprise: determining a time of receipt associated with each received activation signal; and determining the activation sequence based on the time of receipt associated with each received activation signal and the unique ID associated with each battery cell. Determining the time of receipt may comprise using a clock to measure the time of receipt of the activation signal.

In accordance with some embodiments, each processing device may comprise a clock configured to begin measuring time when the processing device first activates during assembly of the battery system. The method may further comprise: receiving the time coordinate, wherein a different time coordinate is associated with each processing device, the time coordinate being indicative of a time laps occurring between first activation of the associated processing device and transmission of the activation signal associated with each one of the plurality of battery cells; determining a time difference between the time coordinates associated with each received activation signal; and determining the activation sequence defining the order in which the processing devices associated with the plurality of battery cells first activate based on the determined time different between the time coordinates associated with each received activation signal.

In accordance with yet a further aspect of the disclosure, there is provided a processor for determining a position of a battery cell within a battery system comprising a plurality of battery cells, each battery cell having a unique ID, and each battery cell comprising a processing device configured to emit an activation signal, the battery system being assembled in accordance with a predefined assembly sequence. The processor may be configured to: receive an activation signal associated with each one of the plurality of battery cells comprised within the battery system, each activation signal enabling the unique ID of the associated battery cell to be obtained; associate a time coordinate with ach received activation signal; determine an activation sequence defining an order in which the processing devices associated with the plurality of battery cells are activated based on the time coordinate associated with each received activation signal and the unique ID associated with each battery cell; and determine the position of each battery cell based on the activation sequence and the predefined assembly sequence.

In accordance with yet a further aspect of the disclosure there is provided a battery management system (BMS) comprising any one of the aforementioned processors.

Yet a further aspect of the disclosure comprises a computer program product comprising computer-executable instructions, which when executed by one or more processor, cause the one or more processors to perform any one of the aforementioned methods.

In accordance with yet a further aspect of the disclosure, there is provided a non-transitory storage device comprising computer-executable instructions which when executed on one or more processors, configure the one or more processors to carry out any one of the aforementioned methods.

### Brief Description of Drawings

Figures 1a and 1b are schematic illustrations of known prior art battery systems, which have both been described in detail in the background section.

In the succeeding sections of the disclosure, specific embodiments of the disclosure will be described, by way of non-limiting example only, with reference to the accompanying figures, in which:
Figure 2 is a process flow chart illustrating an exemplary method of determining a position of a battery cell using a voltage measurement, in accordance with an embodiment;
Figure 3 is a schematic illustration of a system for determining a position of a battery cell using a voltage measurement device, in accordance with an embodiment;
Figure 4 is a process flow chart illustrating an exemplary method of determining the position of two or more battery cells using a voltage measurement device, in accordance with an embodiment;
Figure 5 is a schematic illustration of a system for determining a position of a battery cell using an electrical load device configured to draw current from a connected battery cell, in accordance with an embodiment;
Figure 6 is a process flow chart illustrating an exemplary method for determining the position of a battery cell using an operatively connected electrical load device external to the battery cell, in accordance with an embodiment;
Figure 7 is a schematic illustration of a system for determining a position of two or more battery cells within a battery system, using time coordinates associated with received activation signals, in accordance with an embodiment;
Figure 8 is a process flow chart illustrating a method of determining the position of two or more battery cells within a battery system, using time coordinates associated with received activation signals, in accordance with an embodiment;
Figure 9 is a process flow chart illustrating a method of determining the position of two or more battery cells within a battery system, using time coordinates associated with a clock value local to each battery cell, in accordance with an embodiment;

### Detailed Description of Embodiments

In the following description of illustrative embodiments, like numbered reference numerals appearing in different figures will be used to refer to the same features.

Different embodiments of the present disclosure provide different solutions enabling one or more battery cells comprised within a battery system comprising a plurality of cells, to be distinguished from other battery cells within the battery system. Once individual cells are distinguishable from adjacent cells within the battery system, then the individual positions of the cells may be determined.

As used herein, by position of a battery cell is intended the location of the battery cell relative to another object. For example, in most embodiments the position of a battery cell is defined with respect to other battery cells comprised within a battery system. In other words, by position of the battery cell within the battery system is intended the relative position of the battery cell within the battery system.

Notwithstanding the above, in certain embodiments the location of a battery cell may be determined. By location of the battery cell is intended the geographical position.

### Determining battery position on the basis of battery cell voltage

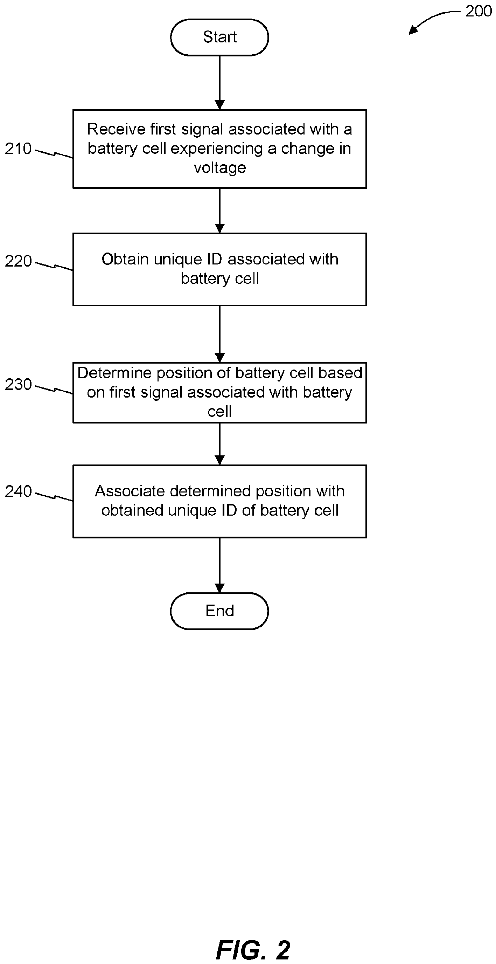

Figure 2 is a process flow chart illustrating a method 200 of determining a position of a battery cell within a battery system comprising a plurality of battery cells, each battery cell having a unique identifier (ID), and each battery cell being configured to experience a change in voltage when an electrical stimulus is applied to the battery cell. The electrical stimulus may relate to a positive stimulus, or to a negative stimulus. The change in voltage induced by the electrical stimulus in the connected battery cell is used to distinguish the affected battery cell from adjacent battery cells.

For non-limiting illustrative purposes, in the succeeding embodiments the electrical stimulus relates to a negative stimulus, and more particularly comprises an electrical load configured to draw current from a connected battery cell. However, it is to be appreciated that any electrical stimulus may be used which causes a change in an electrical characteristic of the connected battery cell, such as a change in voltage.

Returning to Figure 2, the method comprises receiving a first signal associated with a first battery cell experiencing a change in voltage due to an electrical load applied to the battery cell, at step 210. The unique ID associated with the battery cell experiencing the change in voltage is obtained, at step 220. The position of the battery cell is determined based on the received first signal associated with the battery cell, at step 230. The determined battery cell position is then associated with the unique ID of the battery cell, at step 240. The first signal enables the battery cell experiencing the change in voltage to be distinguished from the plurality of other battery cells comprised in the battery system. Once the cell experiencing the change in voltage is distinguishable from adjacent cells, its position may be determined.

In accordance with some embodiments, method 200 may be repeated for all battery cells comprised within the battery system, thereby enabling a position to be associated with each cell within the battery system, and more specifically, enabling a position to be mapped to each unique ID of each battery cell. During manufacture of the battery system, and during manufacture of the battery cells, a unique ID is associated to each cell. However, unless the position of each cell is mapped during assembly of the battery system, the position of each cell, as identified by its associated unique ID, is unknown. Thus, whilst the unique ID of each battery cell comprised within the battery system may be known, the positions of the cells are unknown.

In accordance with certain embodiments, the determined position information may be stored in a non-transitory storage device. For example, the battery cell position information may be stored in a database within a memory. The battery cell position information may be used to complement cell analytics monitoring system, such as a fault detection system, although this is but one non-limiting example of how the battery cell position information, obtained using the herein disclosed methods and apparatus, may be used. The present disclosure does not limit how the determined battery cell position information may be used.

As used herein, the term unique ID is to be understood as any identifier which uniquely identifies a cell within a battery system. Accordingly, the unique IDs associated with the different battery cells comprised within a battery system differ from each other to uniquely identify the associated battery cell. It suffices for the purposes of the present disclosure that the unique ID is unique with respect to the unique IDs associated with the other battery cells comprised in a battery system, to avoid any two or more battery cells comprised within a battery system sharing the same ID. In accordance with embodiments of the disclosure, the unique ID may be comprised of a string comprising one or more characters that uniquely identify the associated battery cell. For example, the unique ID may comprise any one or more of: a number, an alphanumeric string, a sequence of numerals, a string of letters, or a sequence of visual indicia.

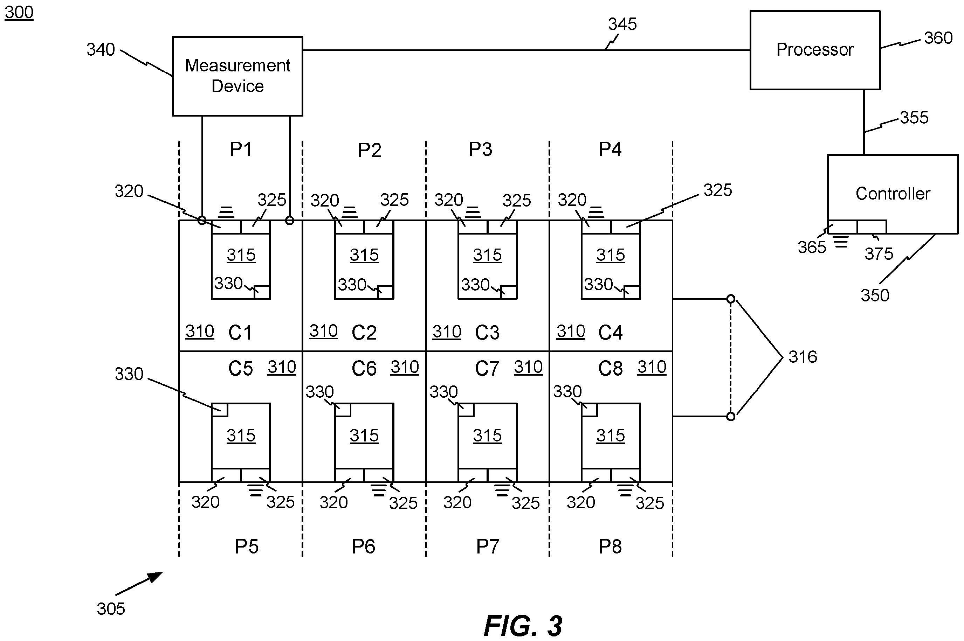

Figure 3 is a schematic illustration of an arrangement of apparatus 300 configured to implement the method of Figure 2, in accordance with a non-limiting embodiment. Battery system 305 comprises a plurality of battery cells 310, and terminals 316 enabling current to be drawn from battery system 305. One or more battery cells 310 may be connected in series or, in some embodiments, in parallel. When connected in series, the voltage across terminals 316 may be the sum of the individual cell voltages. As mentioned previously, each battery cell 310 may be associated with a different unique ID. For illustrative purposes, designations C1 to C8 are used to represent the different unique IDs associated with each different battery cell 310. Each battery cell C1 to C8 is located at a different position within battery system 305. The different positions of battery cells 310 are designated, for illustrative purposes, P1 to P8, in Figure 3.

Each battery cell 310 comprises an electrical device 315. Electrical device 315 may comprise transmitter 320 and receiver 325, configured to enable the associated battery cell to communicate wirelessly with controller 350, which itself comprises a transmitter 365 and receiver 375. In the embodiment of Figure 3, each electrical device 315 comprises an operatively connected electrical load 330. Electrical load 330 may be configured to draw current from battery cell 310 it is operatively connected to when in an active state, and cause a change in voltage across the associated battery cell 310. When in an inactive state, electrical load 330 does not draw current from the associated battery cell 310, and there is no corresponding change in voltage across the associated battery cell 310. Each electrical load 330 may be activated in response to receipt of a control signal from controller 350. The control signal may be received via the battery cell's receiver 325, which is operatively coupled to electronic device 315 comprising operatively coupled electrical load 330.

In accordance with some embodiments, electrical device 315 may comprise an Application-Specific Integrated Circuit (ASIC) chip. The ASIC chip may be configured for one or more specific tasks, including monitoring one or more physical characteristics of battery cell 310 it is connected to. For example, the ASIC chip may be configured to monitor any one or more of: pressure, current, or voltage within battery cell 310. The ASIC chip may be configured to carry out any desired application. For the purposes of the present disclosure, it is immaterial what the desired application is.

In accordance with some embodiments, the unique ID associated with each battery cell 310 may be predetermined. For example, during manufacture or assembly of battery system 305. Controller 350 may be provided with access to the unique ID associated with each battery cell 310, and use the unique IDs to selectively instruct a specific battery cell to activate its associated electrical load 330.

Measurement device 340 may comprise a voltage measurement device configured to measure a voltage across a specific battery cell 310 it is connected to. Measurement device 340 communicates measurement data, for example voltage measurement data, with processor 360 via shared communication channel 345. Similarly, controller 350 may be configured to communicate with processor 360 via shared communication channel 355. Shared communication channels 345 and 355 may comprise wired or wireless communication channels.

It is to be appreciated that the functionality of transmitters 320 and receivers 325 comprised on each battery cell 310 may, in some embodiments, be replaced with transceivers configured to receive and to transmit wireless communication signals. Similarly, the functionality of transmitter 365 and receiver 375 of controller 350 may be replaced with a transceiver. In some embodiments, controller 350 may be provided with wired communication channels to communicate with each battery cell 310.

As used herein, wireless communications and communication channels may relate to radio-frequency (RF) communication protocols and channels, including Near-Field Communication (NFC), and Bluetooth^{®} communication protocols, or any other wireless communication standard.

In accordance with some embodiments, measurement device 340 may be configured to vary its position relative to battery system 305, to enable it to connect to different battery cells 310. For example, measurement device 340 may be configured to vary its position relative to battery system 305 along a guide track (not shown) configured around battery system 305. The guide track may be configured on an external frame having a size and shape complementary to the shape of battery system 305. Measurement device 340 may be configured to move along the guide track to connect to different battery cells. Movement along the guide track may be automated. In certain embodiments, movement of measurement device 340 may be controlled by an external controller, which in certain embodiments may comprise controller 350. In certain embodiments, movement of measurement device 340 may be controlled by an external human operator using a controller, such as a remote control.

In some embodiments, the position of measurement device 340 relative to battery system 305 may be manually varied by a human operator of apparatus 300.

In accordance with some embodiments, the position of measurement device 340 of Figure 3, may be defined relative to a known schematic of battery system 305. For example, the position of measurement device 340 may be defined with respect to position P1 obtained from an available schematic of battery system 305. Positions P1 through P8 of the plurality of battery cells 310 may be known from the schematic of battery system 305. However, the identity, as defined by the cell's unique ID, of the specific battery cell occupying a specific position is unknown. Using the known schematic, measurement device 340 may be positioned relative to any one of known cell positions P1 to P8.

In certain embodiments, measurement device 340 may be configured with a position determining device enabling measurement device 340 to determine its position relative to battery system 305. The position determining device may comprise any one or more of: a Global Positioning System (GPS), an Inertial Navigation System (INS), a linear transducer, or any other position determining device.

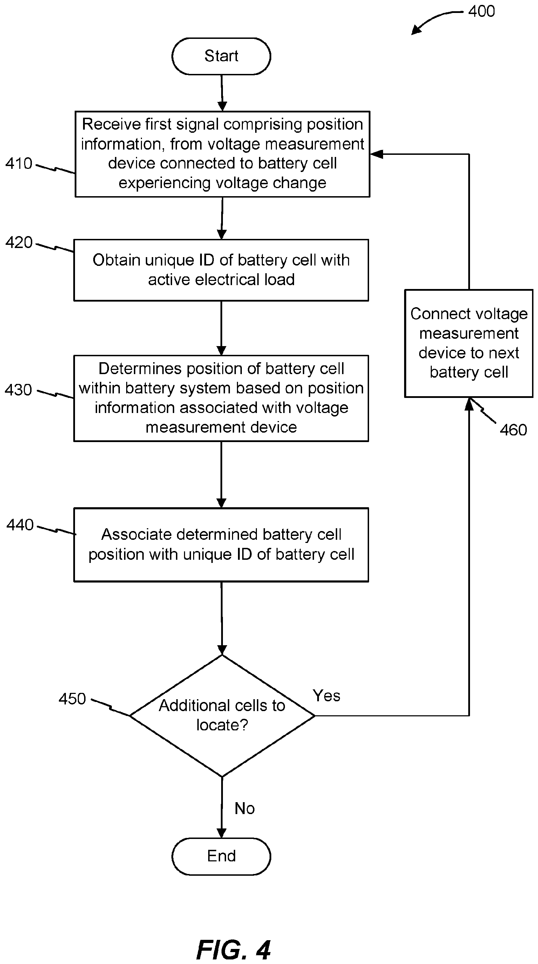

Processor 360 is configured to determine the position of battery cell 310 experiencing a change in voltage due to its associated electrical load device 330 being active, from position information received from measurement device 340, when connected to the battery cell 310 experiencing the voltage change. Processor 360 may be configured to obtain unique ID information of the associated battery cell experiencing the voltage change due to active electrical load device 330, from controller 350. Further details are discussed with reference to the method of Figure 4 below.

Figure 4 is a process flow chart illustrating a method 400 for determining the position of a battery cell using the apparatus 300 of Figure 3. Method 400 commences once electrical load device 330 comprised on at least one battery cell 310 is active, and drawing current from the associated battery cell. With reference to Figure 3, and for the purposes of illustrating method 400 of Figure 4, electrical load device 330 of battery cell C1 is activated on instruction received from controller 350. Once measurement device 340 is connected to battery cell C1, a voltage measurement is made. When measurement device 340 measures a change in voltage, then this is indicative that an electrical load is drawing current from cell C1. A change in voltage may comprise a voltage measurement below a predefined threshold voltage value associated with the cell's voltage when no current is being drawn from the cell. A measured change in voltage is indicative of a voltage drop across cell C1, confirming that measurement device 340 is connected to battery cell C1 from which an active electrical load device 330 is drawing current.

A first signal, comprising position information associated with battery cell C1, is received from measurement device 340, by processor 360, at step 410. Whilst for present purposes the first signal is described, and illustrated in Figure 3, as being received by processor 360 directly from measurement device 340, it is to be appreciated that the first signal may be received by the processor 360 via any one or more proxy devices. For example, the first signal may be received by processor 360, from measurement device 340 via controller 350. Of relevance for present purposes, is that position information associated with cell C1 experiencing the voltage change resulting from electrical load device 330 being active and drawing current from battery cell C1, is received.

In accordance with some embodiments, the first signal may comprise first position information associated with the position of measurement device 340 relative to battery cell C1. The position of battery cell C1 may be determined from the first position information of measurement device 340. In accordance with some embodiments, the relative position of battery cell C1 with respect to the other adjacent cells C2 to C8 is determined. Relative position information of cell C1 may be determined from the position information of measurement device 340. Position information of measurement device 340 may be obtained from a position determining device comprised in or local to measurement device 340.

At step 420, processor 360 obtains the unique ID C1 associated with the battery cell experiencing the change in voltage. In accordance with some embodiments, the unique ID may be obtained from controller 350, which was used by controller 350 to instruct battery cell C1 to activate its associated electrical load device 330. For example, controller 350 may maintain a log or record of which battery cell was instructed, and this information may be obtained by processor 360 to determine the unique ID of battery cell C1 experiencing the change in voltage. In certain embodiments, controller 350 may send the unique ID of battery cell C1 to processor 360. This may be done once controller 350 has instructed a specific battery cell, in this example battery cell C1, to activate its associated electrical load.

The sequence of steps 410 and 420 is shown for illustrative purposes only, in Figure 4. It is to be appreciated though that in accordance with some embodiments step 420 may precede step 410. The specific order in which these two steps are carried out is immaterial for present purposes, suffice it that processor 360 obtains both the first signal comprising position information associated with the battery cell experiencing the change in voltage, and the unique ID of the battery cell experiencing the change in voltage. The order in which this information is obtained is immaterial.

The position of battery cell C1 may be determined from the received position information associated with measurement device 340, at step 430. As mentioned previously, this may comprise inferring a relative position of cell C1 within battery system 305, with respect to the other cells 310 within battery system 305, on the basis of position information associated with the position of measurement device 340 connected to cell C1. For example, in relation to Figure 3, where C1 is the cell experiencing the change in voltage, this may comprise determining that cell C1 is located in the top left hand corner of battery system 305, on the basis of the position of measurement device 340 relative to battery system 305 when connected to cell C1 experiencing the change in voltage. In some embodiments, determining the position of cell C1 experiencing the change in voltage, may comprise inferring a coordinate position of cell C1 on the basis of geographical coordinates associated with the position of measurement device 340 connected to cell C1.

The determined position information of cell C1 may subsequently be associated with the obtained unique ID, at step 440, by processor 360. At this stage, the position of cell C1 within battery system 305 is known. This information may, in some embodiments, be stored for later use by, for example, a fault monitoring system, and/or a BMS (not shown). In some embodiments, the position information, once determined, may be stored local to the battery cell, for example, within electronic device 315.

At step 450 it is determined if any other battery cells 310 within battery system 305 require locating. This may be achieved with reference to the list of known unique IDs available to controller 350. Method 400 is ended if no further battery cells 310 require locating. Otherwise, controller 350 instructs another battery cell 310 to activate its electrical load device, and measurement device 340 is repositioned and connected to another battery cell 310 comprised within battery system 305. A voltage measurement is taken, and if no voltage drop is measured, measurement device 340 is repositioned and connected to another battery cell. This process is repeated iteratively, at step 460, until measurement device 340 measures a voltage drop across the battery cell it is connected to. This is indicative that measurement device 340 is connected to battery cell 310 requiring locating, and which is experiencing the change in voltage due to its associated electrical load device 330 being active and drawing current from it. Steps 410 through 450 are repeated, until the positions of all required battery cells comprised in battery system 305 have been determined.

In accordance with some embodiments, apparatus 300 may comprise a plurality of measurement devices, each connected to and positioned relative to a different one of the plurality of battery cells 310. Such embodiments may function in a similar way as described in relation to Figures 3 and 4 previously, except it may be unnecessary to reposition any one of the measurement devices, where each battery cell 310 has a different measurement device connected to it. Instead, as an electrical load device of a specific battery cell is activated, the connected measurement device will measure the corresponding change in voltage, and position information associated with the associated measurement device and the unique ID of the associated battery cell is provided to processor 360 in a similar way as previously described in relation to Figures 3 and 4. Such embodiments may obviate the need to provide a guide rail or other displacement means enabling the position of measurement device 340 to be varied relative to battery system 305.

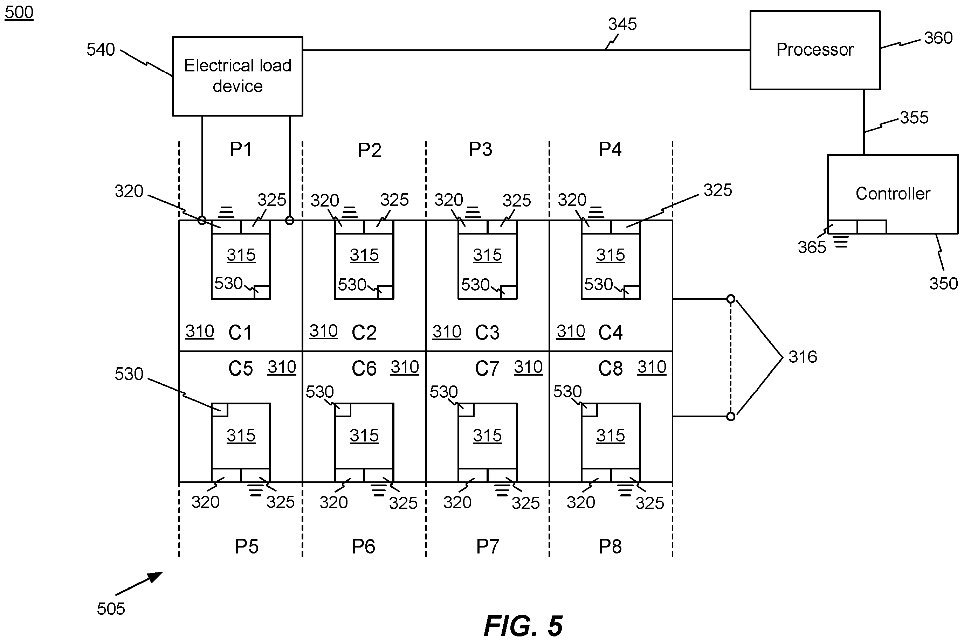

Figure 5 is a schematic illustration of an arrangement of apparatus 500, in accordance with some embodiments of the disclosure. In contrast with the apparatus 300 of Figure 3, each battery cell 310 comprises measurement device 530 local to it, and an external electrical load device 540 is selectively connected to one of battery cells 310 to cause a change in voltage across the battery cell 310 it is connected to. In other words, with respect to apparatus 300 of Figure 3, the measurement device and the electrical load device have been inverted - electrical load device 540 is external to and selectively connectable to any one of battery cells 310, and measurement device 530 is local to each battery cell 310.

In accordance with some embodiments, and as illustrated in Figure 5, measurement device 530 is comprised in electrical device 315. In other embodiments, measurement device 530 may be separate from electrical device 315, albeit connected to an associated battery cell 310 and configured to measure a change in voltage experienced by its associated battery cell 310.

For non-limiting illustrative purposes, in Figure 5 external electrical load device 540 is connected to and drawing current from battery cell C1, causing a change in voltage across cell C1. The change in voltage caused by external electrical load device 540 is measured by measurement device 530 local to cell C1. Cell C1 may be configured to send a signal to controller 350 when its measurement device 530 measures a change in voltage. For example, transmitter 320 may be configured to transmit a signal to controller 350 when the voltage across cell C1 drops below a threshold voltage value. The transmitted signal enabling controller and/or processor 360 to obtain the unique ID of cell C1, as described in relation to preceding embodiments. For example, in accordance with some embodiments, the transmitted signal may comprise information enabling the unique ID of cell C1 to be determined. In some embodiments the signal may comprise the unique ID of cell C1.

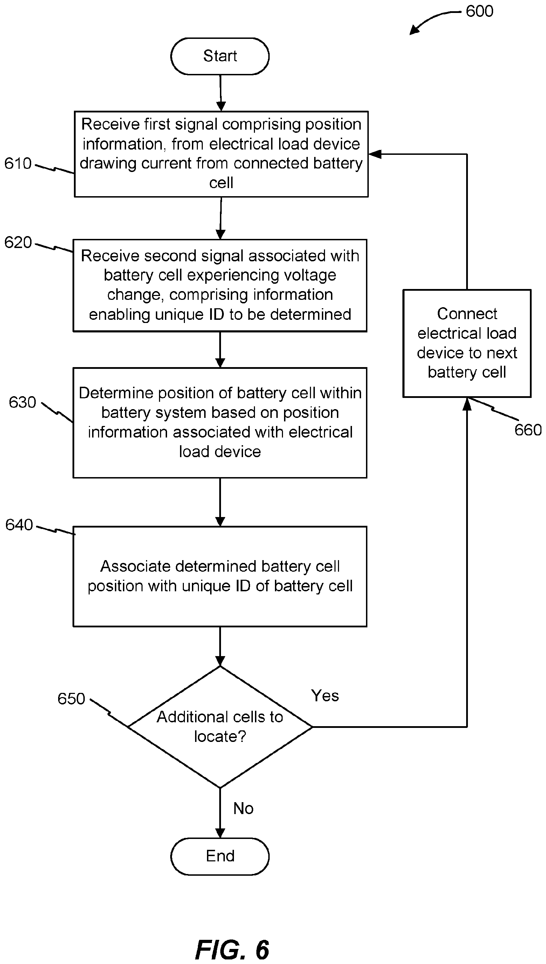

Figure 6 is a process flow chart illustrating a method 600 of determining the position of a battery cell experiencing a change in voltage, using apparatus 500 of Figure 5, in accordance with some embodiments. As mentioned previously, when external electrical load device 540 is positioned relative to battery cell C1 and draws current from cell C1, local measurement device 530 measures a change in voltage across cell C1. A first signal comprising position information associated with the position of the electrical load device 540, is received by processor 360, from electrical load device 540, at step 610.

A second signal associated with battery cell C1 experiencing the change in voltage, is received from cell C1 at processor 360 via controller 350, at step 620. In some embodiments, the second signal may be received directly by processor 360 from cell C1, where processor 360 is configured with a wireless receiver, or is provided with a wired communication channel to cell C1.

In common with method 400 of Figure 4, the sequence in which steps 610 and 620 are carried out is immaterial, suffice it that processor 360 obtains both the first signal comprising position information associated with the position of external electrical load device 540, and the second signal comprising information enabling the unique ID of the cell experiencing the voltage change to be determined.

The position of battery cell C1 is determined by processor 360, based on the position information comprised in the received first signal - in other words, based on the position information associated with external electrical load device 540 drawing current from cell C1 - at step 630. For example, in Figure 5, external electrical load device 540 is at position P1 relative to cell C1, and the position of cell C1 may be defined relative to position P1. The determined battery cell position is subsequently associated with the obtained unique ID, at step 640, in a similar manner as described in preceding embodiments. At this stage, the position of cell C1 within battery system 505 is known, and this information may be stored for later use, as described previously.

It is to be appreciated, that in common with preceding embodiments, the position of electrical load device 540 may be defined with respect to a known cell position obtained from a known schematic of battery system 505.

At step 650 it is determined by processor 650 if any additional battery cells 310 require locating. If one or more further battery cells 310 require locating, then external electrical load 540 is relocated to a new position relative to a different battery cell 310 comprised within battery system 505 requiring locating, and current is drawn from the new battery cell external electrical load 540 is connected to, at step 660. Method steps 610 through 650 are repeated for the new battery cell external electrical load device 540 is connected to, until all required battery cells 310 have been located.

In some embodiments, apparatus 500 may comprise a plurality of external electrical load devices (not shown), each positioned relative to a different one of battery cells 310, and each configured to draw current from a different one of the cells 310. In such embodiments, relocating external electrical load device 540 may be unnecessary. The position of one or more battery cells may be determined in the same manner as described in relation to Figure 6, with the exception that step 660 is unnecessary. In some embodiments where each battery cell is associated with a different external electrical load device, each one of the plurality of external electrical load devices may draw current from its associated battery cell simultaneously, and each battery cell may transmit the second signal simultaneously. In such embodiments, processor 360 may be configured to batch process the received signals.

Alternatively, the plurality of external electrical load devices may activate at different times in a random sequence or in a predefined sequence, such that only one external electrical load draws current from its associated battery cell at any one time, and consequently each battery cell experiences a change in voltage at a different time. In such embodiments, first and second signals associated with a particular battery cell experiencing a change in voltage are received at different times, at processor 360.

In accordance with embodiments of the present disclosure, electrical load device 330 of Figure 3 and/or external electrical load device 540 of Figure 5 may comprise any electrical circuit configured to provide a positive or a negative stimulus to the battery cell, which is measurable. For example, and as has been described in relation to the previous embodiments, the electrical load may be configured to draw current and consume electrical power from the battery cell it is connected to. For example, the electrical circuit may comprise a balancing load and/or balancing circuit. The balancing circuitry may relate to existing balancing resistor hardware present at the battery cell. In this way, the disclosed methods may be implemented with little to no additional hardware required at the cell.

In some embodiments, the electrical load device may be an energy dissipative passive device such as a resistor, or an active device such as a transistor.

In some embodiments the electrical load device may be an energy transfer device such as a DC to AC or DC to DC converter, configured to discharge the battery cell.

It is to be appreciated that the voltage change caused by the electrical load device may correspond to an observed pulse change in voltage. For example, the voltage change may be observed as a temporary change in voltage, in which the measured voltage value diverges from a base voltage value for only a transient period of time.

In some embodiments, the electrical load device may be configured to provide a pulsed stimulus. For example, the electrical load may be configured to draw current from the battery cell in short temporary bursts, thereby provoking a series of measurable voltage measurement pulses.

In accordance with further embodiments, both measurement device 340 and electrical load device 330 may be remotely located from battery system 305. In such embodiments a different remotely located electrical load device may be operatively coupled to each battery cell 310. Each remotely located electrical load forms an electrical circuit with the battery cell it is operatively coupled to, and may be activated by controller 350 instructing the associated battery cell, as described in relation to previous embodiments. Measurement device 340 measures a voltage change caused by the activated electrical load. Processor 360 determines the position of the battery cell experiencing the voltage change, in a similar manner as described in relation to previous embodiments.

In some embodiments comprising both remotely located measurement devices and remotely located electrical load devices, controller 350 may instruct a specific remotely located electrical load to activate causing a change in voltage in the connected battery cell. The battery cell experiencing the change in voltage may transmit its unique ID to controller 350 and/or processor 360. In such embodiments, it is not necessary for controller 350 to have access to the unique IDs of the plurality of battery cells 310. Instead, each battery cell may comprise its associated unique ID in local storage, for example in a storage of electronic device 315.

In some embodiments, electrical load device may be replaced with a positive stimulus device. For example, electrical load device may be replaced with a charger, configured to charge the battery cell it is operatively connected to. Electrical load device 540 may be replaced with a charging circuit. The herein disclosed methods for determining the position of a battery cell may be implemented using either a positive or a negative electrical stimulus. Irrespective of whether a positive or a negative electrical stimulus is used, the methods for determining battery cell position do not fundamentally change.

### Determining battery position on the basis of cell activation sequence

In accordance with some embodiments of the disclosure, battery cell position is determined on the basis of a battery cell activation sequence and a predefined assembly sequence. During assembly of a battery system, individual battery cells are assembled, and incorporated within the battery system. This includes placing each battery cell within the battery system at specific locations, in accordance with a predefined assembly sequence. At some stage during the assembly process, each battery cell is activated to ensure that it is functioning correctly within the battery system. This may occur as each battery cell is placed within the battery system, or once all battery cells have been placed within the battery system. A record of where each battery cell is located within the battery system, as identified by its unique ID, is often not maintained. In such cases, and in accordance with some embodiments, the position of each battery cell within the battery system may be determined based on the activation sequence in combination with the predefined assembly sequence. Further details of such embodiments are set out below.

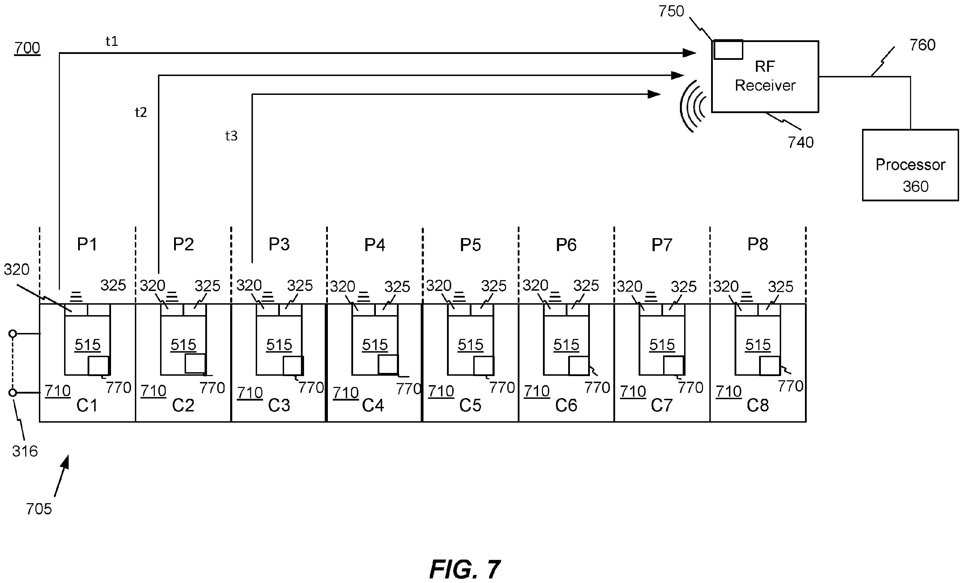

Figure 7 is a schematic illustration of an arrangement of apparatus 700, comprising battery system 705, radio-frequency (RF) receiver 740 and processor 360. Battery system 705 comprises a plurality of battery cells 710, placed within battery system 705 in accordance with a predefined assembly sequence. Each battery cell 710 has a unique ID, which uniquely identifies the cell within battery system 705. In Figure 7 the unique IDs are designated C1 through C8 for illustrative purposes. Each battery cell 710 is associated with a different position, designated P1 through P8, again for purposes of illustration only. The predefined assembly sequence defines the sequence in which positions P1 through P8 are to be occupied by battery cells 710 during assembly.

Each battery cell 710 comprises processing device 715. Processing device 715 may be a microprocessor. In some embodiments, processing device 715 may be an Application-specific Integrated Circuit (ASIC). Each cell 710 may comprise an RF transmitter 320 configured to transmit RF signals to RF receiver 740. Battery cells 710 may be configured to transmit an activation signal to RF receiver 740 when they are first activated during assembly. In some embodiments, the activation signal may be transmitted as processing device 715 comprised on each cell 710 is first activated during assembly.

In accordance with some embodiments, RF receiver 740 may comprise clock 750 configured to measure a time coordinate associated with each received activation signal. For illustrative purposes, in Figure 7, a first activation signal received from cell C1 at time t₁ as measured by clock 750 is designated **t1**; a second activation signal received from cell C2 at time t₂ is designated **t2;** and a third activation signal received from cell C3 at time t₃ is designated **t3.** The measured time coordinate may relate to a time of receipt of each received activation signal.

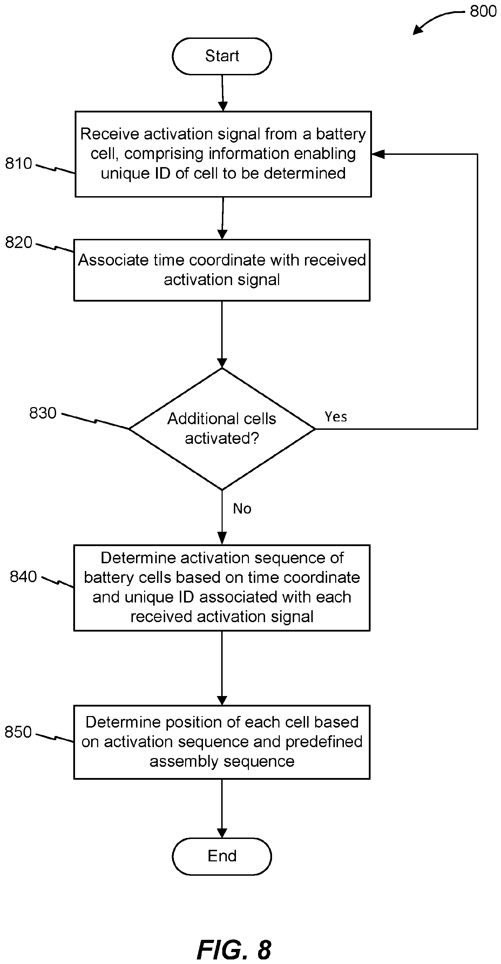

Figure 8 is a process flow chart illustrating a method 800 of determining a position of a battery cell within a battery system, using the arrangement of apparatus 700 of Figure 7. Method 800 may be carried out by processor 360 during assembly of battery system 705. With reference to Figure 7, the predefined assembly sequence comprises assembling cells C1 to C8 sequentially within battery system 705. In other words, first cell C1 is placed within battery system 705, followed by cell C2, then C3 and so forth until all eight cells have been placed within battery system 705.

Once cell C1 has been placed within battery system 705, its associated processing device 715 activates, and activation signal **t1** is sent to RF receiver 740. Activation signal **t1** is received by RF receiver 740, at step 810. Activation signal **t1** comprises information enabling the unique ID of cell C1 to be determined. In some embodiments, and as described in relation to preceding embodiments, activation signal **t1** may comprise the unique ID of cell C1. A time coordinate is associated with the received activation signal, by processor 360, at step 820. The time coordinate may relate to a time of receipt of activation signal **t1** by RF receiver 740, measured by clock 750. RF receiver 740 and processor 360 share communication channel 760, enabling signals and measured time coordinates to be provided to processor 360. It is to be appreciated that for non-limiting illustrative purposes only, RF receiver 740 and processor 360 are illustrated as separate devices, but in some embodiments may be comprised in the same device, and/or their functionality may be provided by the same physical device.

If any additional battery cells are placed into battery system 705 and activated at step 830, then steps 810 and 820 are repeated for each received activation signal associated with a newly activated battery cell. For example, as cell C2 is placed within battery system 705, activation signal **t2** is received and steps 810 and 820 are repeated. The same steps are repeated with activation signal **t3,** and so forth.

Remaining method steps 840 and 850 may be performed by processor 360 once at least two activation signals associated with two different activated battery cells have been received. However, in certain embodiments the remaining method steps 840 and 850 are performed once all battery cells comprised in battery system 705 have been activated, and for present purposes the remaining steps of method 800 will be described in relation to such an embodiment.

Once cells C1 through C8, and more specifically their associated processing devices 715 have been activated, and a time coordinate associated with a time of receipt of each received activation signal has been associated to each received activation signal, an activation sequence defining the order in which processing devices 715 have been activated, is determined by processor 360, at step 840. The order in which the different processing devices 715 were activated is synonymous with the order in which battery cells 710 were assembled within battery system 705. The activation sequence identifies the order in which the plurality of battery cells 710, as identified by their respective unique IDs, were assembled within battery system 705.

The position of each battery cell 710 within battery system 705 is determined, on the basis of the activation sequence and the known predefined assembly sequence, at step 850. The predefined assembly sequence defines a physical order in which the plurality of battery cells 710 within battery system 705 are to be assembled. In other words, the assembly sequence defines a positional sequence in which the plurality of battery cells 710 are to be installed within battery system 710. As mentioned previously, this may comprise defining the sequence in which battery cell positions P1 to P8 are occupied by battery cells 710 during battery system assembly. The predefined assembly sequence may be comprised within the assembly procedure for battery system 705.

An example of a predefined assembly sequence, with reference to Figure 7, may be that the plurality of battery cells 710 are to be sequentially installed from left to right - that is cell positions P1 to P8 are to be filled in numerical sequence. The predefined assembly sequence does not provide information regarding the identity of the cells, it provides positional information indicating the sequence in which the available positions within battery system 705 are filled during assembly by battery cells 710. Instead, the activation sequence provides information identifying specific battery cells, and the order in which they were activated in time. Therefore, one way of determining the position of a battery cell 710 within battery system 705 is to associate the determined activation sequence with the predefined assembly sequence. This may comprise mapping activation sequence data with assembly sequence data. For example, this may comprise associating each unique ID associated with each received activation signal, to a specific position within battery system 705 as defined by the predefined assembly sequence.

One way in which the activation sequence may be determined is to arrange each received activation signal in order of the time of receipt. In other words, by determining a chronological order of receipt of the activation signals. The chronological order of receipt of the activation signals is related to the predefined assembly sequence, since the assembly sequence defines the positional order in which battery cells 710 are installed within battery system 705, and consequently the order in which the cells 710 are activated. The unique ID associated with each cell 710 is provided by the activation sequence, whilst the assembly sequence provides the position information. Associating the activation sequence with the assembly sequence results in a specific position being associated with the unique ID of each battery cell 710. It is to be appreciated, that cell activation may relate to the process whereby processing device 715 is fixated to a battery cell 710. Similarly, in some embodiments, cell activation may relate to the process whereby a battery cell 710 comprising processing device 715 is physically inserted and connected to battery system 705.

In some embodiments each processing device 715 may comprise a clock 770 configured to begin measuring time when the associated battery cell 710 is activated. The activation signal transmitted to RF receiver 740 comprises a time coordinate associated with the time of transmission as measured by clock 770 local to cell 710. The time of transmission as measured by clock 770 is indicative of the passage of time from when the associated battery cell and/or processing device 715 was activated, and transmission of the activation signal. Since each battery cell 710, and each processing device 715 is activated at a different time, there will be an inherent time difference between clocks 770 associated with the time delay between the activation of different battery cells 710. One way of mitigating for this time delay present in clocks 770, is for cells 710 to transmit their activation signals at the same time once all battery cells have been activated. This ensures that the time difference between the time coordinates associated with any two or more different received activation signals is directly proportional to the time lapse between activation of the different cells 710 and/or processing devices 715.

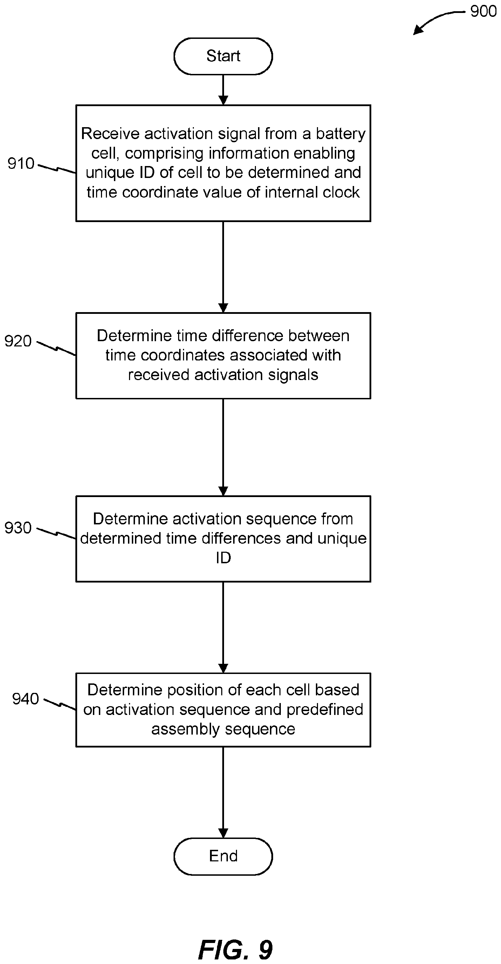

Figure 9 is a process flow chart illustrating a method 900 of determining cell position using time coordinate values measured by clocks 770 local to each battery cell 710, in accordance with embodiments of the disclosure. For purposes of illustration, method 900 is described with respect to apparatus 700 of Figure 7. As each battery cell 710 and/or processing device 715 is activated during assembly, internal clock 770 begins counting the passage of time since the associated battery cell and/or processing device 715 has been activated. Once all battery cells 710 and/or processing devices 715 have been activated, each cell transmits an activation signal to RF receiver 740. The plurality of activation signals are received by RF receiver 740 and provided to processor 360, at step 910. Each received activation signal comprises a time coordinate associated with the transmitting cell, the time coordinate indicative of how much time has passed from activation of the associated cell and/or processing device, and emission of the activation signal. Furthermore, each activation signal also comprises information enabling the unique ID of the associated battery cell 710 to be determined, as disclosed in relation to previous embodiments.

Once each activation signal has been received, processor 360 determines a time difference between the time coordinates associated with the different received activation signals, at step 920. The determined time differences together with the unique IDs may be used to determine the activation sequence from the received activation signals, at step 930. For example, the greatest determined time difference will be determined when comparing the time coordinates of the first activated cell and/or processing device 715, and the last activated cell and/or processing device 715. Similarly, the time difference between two sequentially activated cells and/or processing devices will be smallest. Thus, the activation sequence may be determined by analysing the determined time differences between the time coordinates comprised in the received activation signals. The chronological order in which the plurality of battery cells 710 and/or processing devices 715 were activated is given by the determined activation sequence.

The determined activation sequence may then be associated with the predefined assembly sequence by processor 360, at step 940. The position of each cell 710 within battery system 705 is now known.

In accordance with some embodiments, the predefined assembly sequence may be stored in a memory (not shown) accessible to processor 360. The memory may be local to, or remotely located from, processor 360.

In accordance with some embodiments, rather than receiving a plurality of different activation signals from the plurality of battery cells 710, the plurality of activation signals may be concatenated into a single carrier signal prior to transmission to RF receiver 740. For example, battery system 705 may comprise a modulator configured to concatenate the individual activation signals onto a single carrier signal. In such embodiments, each battery cell 710 may not comprise transmitter 320. Instead, battery cells 710 may be provided with a communication channel connecting each battery cell 710 to a modulator. Once each activation signal has been concatenated and modulated onto a carrier signal, the carrier signal may be wirelessly transmitted to RF receiver 740, via a transmitter operatively coupled to the modulator. In turn, RF receiver 740 may comprise a demodulator configured to demodulate and extract the individual activation signals from the received carrier signal. The associated time coordinates and unique IDs may then be recovered, and processor 360 may proceed to determine battery cell position in a similar manner as described in relation to method 900 of Figure 9.

In accordance with some embodiments, activation signals may relate to short-range wireless signals. For example, they may comprise short-range signals in accordance with any one of near-field communication (NFC) communication protocols, or Bluetooth^{®} communication protocols.

Further features in accordance with embodiments of the disclosure, are outlined in the following clauses:
1. A method of determining a position of a battery cell within a battery system comprising a plurality of battery cells, each battery cell having a unique identifier, ID, and each battery cell configured to experience a change in voltage when an electrical stimulus is applied to the battery cell, the method comprising:
   receiving a first signal associated with a first battery cell experiencing a change in voltage due to an electrical stimulus applied to the battery cell;
   obtaining the unique ID associated with the first battery cell;
   determining the position of the first battery cell, based on the received first signal associated with the first battery cell; and
   associating the determined position with the obtained unique ID of the first battery cell.
2. The method of clause 1, wherein each battery cell comprised within the battery system comprises an electrical stimulus, the electrical stimulus having an active state in which the electrical stimulus causes a change in the voltage of the associated battery cell it is connected to, the method further comprising:
   receiving the first signal from a voltage measurement device connected to the first battery cell when the associated electrical stimulus is in the active state.
3. The method of clause 2, comprising:
   receiving the first signal comprising first position information associated with the position of the voltage measurement device connected to the first battery cell, the first position information comprising information associated with a position of the voltage measurement device relative to the first battery cell; and
   determining the position of the first battery cell within the battery system, based on the first position information.
4. The method of clause 3, wherein the voltage measurement device is configured to change the battery cell it is connected to by varying its position relative to the battery system, the method further comprising the steps of:
   determining if the battery cell the voltage measurement device is connected to is experiencing a change in voltage;
   changing the battery cell the voltage measurement device is connected to if no change in voltage is determined, by varying the position of the voltage measurement device relative to the battery system; and
   iteratively repeating the determining and changing steps until the voltage measurement device measures the change in voltage experienced by the first battery cell when connected to the first battery cell.
5. The method of clause 3, wherein a plurality of voltage measurement devices are positioned at different locations relative to the battery system, each voltage measurement device connected to and positioned relative to a different one of the plurality of battery cells within the battery system, the method further comprising:
   receiving, from the voltage measurement device connected to the first battery cell, the first signal comprising first position information associated with the position of the voltage measurement device connected to the first battery cell.
6. The method of any one of clauses 2 to 5, comprising:
   obtaining, from a controller configured to selectively activate the electrical stimulus of the first battery cell, the unique ID associated with the first battery cell.
7. The method of clause 1, wherein each battery cell comprised within the battery system comprises a voltage measurement device, the voltage measurement device configured to measure a change in voltage experienced by the associated battery cell when a stimulus is applied to the battery cell by an electrical stimulus device connected to the associated battery cell, the method further comprising:
   receiving, from the electrical stimulus device when connected to the first battery cell, the first signal comprising first position information associated with the position of the electrical stimulus device connected to the first battery cell, the first position information comprising information associated with a position of the electrical stimulus device relative to the first battery cell; and
   determining the position of the first battery cell within the battery system, based on the first position information.
8. The method of clause 7, wherein the electrical stimulus device is configured to change the battery cell it is connected to by varying its position relative to the battery system.
9. The method of clause 7, wherein a plurality of electrical stimulus devices are positioned at different locations relative to the battery system, each electrical stimulus device connected to and positioned relative to a different one of the plurality of battery cells within the battery system, the method further comprising:
   receiving, from the electrical stimulus device connected to the first battery cell, the first signal comprising first position information associated with the position of the electrical stimulus device connected to the first battery cell.
10. The method of any one of clauses 7 to 9, further comprising:
   receiving a second signal associated with the first battery cell experiencing the change in voltage, the second signal enabling the unique ID of the first battery cell to be determined.
11. The method of any one of clauses 7 to 9, further comprising:
   receiving a second signal associated with the first battery cell experiencing the change in voltage, the second signal comprising the unique ID of the first battery cell.
12. The method of clause 10 or 11, wherein the second signal is received from the first battery cell.
13. The method of clause 12, wherein each battery cell comprised within the battery system comprises a transmitter configured to transmit the second signal, and the method comprises:
   receiving the second signal transmitted from the first battery cell.
14. The method of any preceding clause, wherein the electrical stimulus comprises:
   an electrical load having an active state in which the electrical load draws current from the associated battery cell it is connected to, and an inactive state in which current is not drawn from the associated battery cell.
15. A processor for determining a position of a battery cell within a battery system comprising a plurality of battery cells, each battery cell having a unique identifier, ID, and each battery cell configured to experience a change in voltage when an electrical stimulus is applied to the battery cell, the processor being configured to:
   receive a first signal associated with a first battery cell experiencing a change in voltage due to an electrical stimulus applied to the battery cell;
   obtain the unique ID associated with the first battery cell;
   determine the position of the first battery cell, based on the received first signal associated with the first battery cell; and
   associate the determined position with the obtained unique ID of the first battery cell.
16. The processor of clause 15, configured to:
   receive the first signal, the first signal being associated with a voltage measurement device connected to the first battery cell, wherein each battery cell comprised within the battery system comprises an electrical stimulus device, the electrical stimulus device having an active state in which the electrical stimulus device causes a change in voltage of the associated battery cell and an inactive state in which no change in voltage is caused in the associated battery cell, and the first signal is associated with the voltage measurement device when the electrical stimulus device associated with the first battery cell is in the active state.
17. The processor of clause 16, configured to:
   receive the first signal comprising first position information associated with the position of the voltage measurement device connected to the first battery cell, the first position information comprising information associated with a position of the voltage measurement device relative to the first battery cell; and
   determine the position of the first battery cell within the battery system, based on the first position information.
18. The processor of clause 17, configured to:
   obtain, from a controller configured to selectively activate the electrical stimulus device of the first battery cell, the unique ID associated with the first battery cell.
19. The processor of clause 15, configured to:
   receive the first signal associated with an electrical stimulus device connected to the first battery cell, wherein each battery cell comprised within the battery system comprises a voltage measurement device, the voltage measurement device configured to measure a change in voltage experienced by the associated battery cell it is connected to caused by the electrical stimulus device connected to the associated battery cell, the first signal comprising first position information associated with the position of the electrical stimulus device when connected to the first battery cell, the first position information comprising information associated with a position of the electrical stimulus device relative to the first battery cell; and
   determine the position of the first battery cell within the battery system, based on the first position information.
20. The processor of clause 19, further configured to:
   receive a second signal associated with the first battery cell experiencing the change in voltage, the second signal enabling the unique ID of the first battery cell to be determined.
21. The processor of clause 19, further configured to:
   receive a second signal associated with the first battery cell experiencing the change in voltage, the second signal comprising the unique ID of the first battery cell.
22. The processor of clause 20 or 21, configured to:
   receive the second signal from a controller configured to communicate with the first battery cell.
23. The processor of any one of clauses 15 to 22, wherein the electrical stimulus device comprises:
   an electrical load having an active state in which the electrical load draws current from the associated battery cell it is connected to, and an inactive state in which current is not drawn from the associated battery cell.
24. A method of determining a position of a battery cell within a battery system comprising a plurality of battery cells, each battery cell having a unique identifier, ID, and each battery cell comprising a processing device configured to emit an activation signal, the battery system being assembled in accordance with a predefined assembly sequence, and the method comprising:
   receiving an activation signal associated with each one of the plurality of battery cells comprised within the battery system, each activation signal enabling the unique ID of the associated battery cell to be obtained;
   associating a time coordinate with each received activation signal;
   determining an activation sequence defining an order in which the processing devices associated with the plurality of battery cells are activated based on the time coordinate associated with each received activation signal and the unique ID associated with each battery cell; and
   determining the position of each battery cell based on the activation sequence and the predefined assembly sequence.
25. The method of clause 24, wherein the predefined assembly sequence defines the physical order in which the plurality of battery cells are positioned within the battery system, the method further comprising:
   determining the position of each battery cell by associating the activation sequence with the physical order in which the plurality of battery cells are positioned within the battery system.
26. The method of clause 25, wherein the predefined assembly sequence defines the physical order in which a different processing device is affixed to each battery cell within the battery system, the method further comprising:
   determining the position of each battery cell by associating the activation sequence with the physical order in which a different processing device is affixed to each battery cell within the battery system.
27. The method of any one of clauses 24 to 26, wherein the processing device is configured to emit the activation signal when the processing device first activates during assembly of the battery system, the method further comprising:
   determining a time of receipt associated with each received activation signal; and
   determining the activation sequence based on the time of receipt associated with each received activation signal and the unique ID associated with each battery cell.
28. The method of clause 27, further comprising:
   determining the activation sequence by determining a chronological order of receipt of the activation signals; and
   determining the position of each battery cell based on the chronological order of receipt of the activation signals and the predefined assembly sequence.
29. The method of any one of clauses 24 to 26, wherein each processing device comprises a clock configured to begin measuring time when the processing device first activates during assembly of the battery system, the method further comprising:
   receiving the time coordinate, wherein a different time coordinate is associated with each processing device, the time coordinate being indicative of a time lapse occurring between first activation of the associated processing device and transmission of the activation signal associated with each one of the plurality of battery cells;
   determining a time difference between the time coordinates associated with each received activation signal; and
   determining the activation sequence defining the order in which the processing devices associated with the plurality of battery cells first activate based on the determined time difference between the time coordinates associated with each received activation signal.
30. The method of clause 29, further comprising:
   determining the activation sequence by determining a chronological order in which each processing device first activates during assembly of the battery system based on the determined time difference between the time coordinates associated with each received activation signal; and
   determining the position of each battery cell based on the chronological order in which each processing device first activates and the predefined assembly sequence.
31. The method of clause 29 or 30, wherein the activation signals associated with the plurality of battery cells comprised within the battery system are received after the battery system is assembled.
32. The method of any one of clauses 29 to 31, wherein the activation signals associated with the plurality of battery cells comprised within the battery system, are received in a single modulated transmission, the method further comprising:
   demodulating the received modulated transmission to recover the activation signal associated with each one of the plurality of battery cells comprised within the battery system.
33. The method of any one of clauses 24 to 32, wherein the activation signal comprises information enabling the unique ID of the associated battery cell to be determined, the method further comprising:
   determining the unique ID of the battery cell from the information comprised in the associated activation signal.
34. The method of any one of clauses 24 to 32, wherein the activation signal comprises the unique ID of the associated battery cell, the method further comprising:
   obtaining the unique ID of the battery cell from the associated activation signal.
35. The method of any one of clauses 24 to 34, wherein the unique ID associated with each battery cell is predetermined.
36. The method of any one of clauses 24 to 35, wherein the activation signal is a short-range communication signal.
37. The method of clause 36, wherein the short-range communication signal is a near-field communication, NFC, signal having a transmission range of less than or equal to five centimetres.
38. A processor for determining a position of a battery cell within a battery system comprising a plurality of battery cells, each battery cell having a unique identifier, ID, and each battery cell comprising a processing device configured to emit an activation signal, the battery system being assembled in accordance with a predefined assembly sequence, the processor being configured to:
   receive an activation signal associated with each one of the plurality of battery cells comprised within the battery system, each activation signal enabling the unique ID of the associated battery cell to be obtained;
   associate a time coordinate with each received activation signal;
   determine an activation sequence defining an order in which the processing devices associated with the plurality of battery cells are activated based on the time coordinate associated with each received activation signal and the unique ID associated with each battery cell; and
   determine the position of each battery cell based on the activation sequence and the predefined assembly sequence.
39. The processor of clause 38, wherein the predefined assembly sequence defines the physical order in which the plurality of battery cells are positioned within the battery system, and the processor is further configured to:
   determine the position of each battery cell by associating the activation sequence with the physical order in which the plurality of battery cells are positioned within the battery system.
40. The processor of clause 39, wherein the predefined assembly sequence defines the physical order in which a different processing device is affixed to each battery cell within the battery system, and the processor is further configured to:
   determine the position of each battery cell by associating the activation sequence with the physical order in which a different processing device is affixed to each battery cell within the battery system.
41. The processor of any one of clauses 38 to 40, wherein the processing device is configured to emit the activation signal when the processing device first activates during assembly of the battery system, and the processor is further configured to:
   determine a time of receipt associated with each received activation signal; and
   determine the activation sequence based on the time of receipt associated with each received activation signal and the unique ID associated with each battery cell.
42. The processor of clause 41, further configured to:
   determine the activation sequence by determining a chronological order of receipt of the activation signals; and
   determine the position of each battery cell based on the chronological order of receipt of the activation signal and the predefined assembly sequence.
43. The processor of any one of clauses 38 to 40, wherein each processing device comprises a clock configured to being measuring time when the processing device first activates during assembly of the battery system, and the processor is further configured to:
   receive the time coordinate, wherein a different time coordinate is associated with each processing device, the time coordinate being indicative of a time lapse occurring between first activation of the associated processing device and transmission of the activation signal associated with one of the plurality of battery cells;
   determine a time difference between the time coordinates associated with each received activation signal; and
   determine the activation sequence defining the order in which the processing devices associated with the plurality of battery cells first activate based on the determined time difference between the time coordinates associated with each received activation signal.
44. The processor of clause 43, further configured to:
   determine the activation sequence by determining a chronological order in which each processing device first activates during assembly of the battery system based on the determined time difference between the time coordinates associated with each received activation signal; and
   determine the position of each battery cell based on the chronological order in which each processing device first activates and the predefined assembly sequence.
45. The processor of clause 43 or 44, wherein the activation signals associated with the plurality of battery cells comprised within the battery system are received after the battery system is assembled.
46. The processor of any one of clauses 43 to 45, wherein the activation signals associated with the plurality of battery cells comprised within the battery system, are received in a single modulated transmission, and the processor is further configured to:
   demodulate the received modulated transmission to recover the activation signal associated with each one of the plurality of battery cells comprised within the battery system.
47. The processor of any one of clauses 38 to 46, wherein the activation signal comprises information enabling the unique ID of the associated battery cell to be determined, and the processor is further configured to:
   determine the unique ID of the battery cell form the information comprised in the associated activation signal.
48. The processor of any one of clauses 38 to 46, wherein the activation signal comprises the unique ID of the associated battery cell, and the processor is further configured to:
   obtain the unique ID of the battery cell from the associated activation signal.
49. The processor of any one of clauses 38 to 48, wherein the unique ID associated with each battery cell is predetermined.
50. The processor of any one of clauses 38 to 49, wherein the activation signal is a short-range communication signal.
51. The processor of clause 50, wherein the short-range communication signal is a near-field communication, NFC, signal having a transmission range less than or equal to five centimetres.
52. A battery management system comprising the processor of any one of clauses 15 to 22, or 38 to 51.
53. A computer program product comprising computer-executable instructions, which when executed by a processor configure the processor to perform the method of any one of clauses 1 to 14, or 24 to 37.
54. A non-transitory storage device comprising computer-executable instructions which when executed on a processor configure the processor to carry out the method of any one of clauses 1 to 14, or 24 to 37.

## Claims

1. A method of determining a position of a battery cell within a battery system comprising a plurality of battery cells, each battery cell having a unique identifier, ID, and each battery cell configured to experience a change in voltage when an electrical stimulus is applied to the battery cell, the method comprising:
receiving a first signal associated with a first battery cell experiencing a change in voltage due to an electrical stimulus applied to the battery cell;
obtaining the unique ID associated with the first battery cell;
determining the position of the first battery cell, based on the received first signal associated with the first battery cell; and
associating the determined position with the obtained unique ID of the first battery cell.

2. The method of claim 1, wherein each battery cell comprised within the battery system comprises an electrical stimulus, the electrical stimulus having an active state in which the electrical stimulus causes a change the voltage of the associated battery cell it is connected to, the method further comprising:
receiving the first signal from a voltage measurement device connected to the first battery cell when the associated electrical stimulus is in the active state.

3. The method of claim 2, comprising:
receiving the first signal comprising first position information associated with the position of the voltage measurement device connected to the first battery cell, the first position information comprising information associated with a position of the voltage measurement device relative to the first battery cell; and
determining the position of the first battery cell within the battery system, based on the first position information.

4. The method of claim 3, wherein the voltage measurement device is configured to change the battery cell it is connected to by varying its position relative to the battery system, the method further comprising the steps of:
determining if the battery cell the voltage measurement device is connected to is experiencing a change in voltage;
changing the battery cell the voltage measurement device is connected to if no change in voltage is determined, by varying the position of the voltage measurement device relative to the battery system; and
iteratively repeating the determining and changing steps until the voltage measurement device measures the change in voltage experienced by the first battery cell when connected to the first battery cell.

5. The method of claim 3, wherein a plurality of voltage measurement devices are positioned at different locations relative to the battery system, each voltage measurement device connected to and positioned relative to a different one of the plurality of battery cells within the battery system, the method further comprising:
receiving, from the voltage measurement device connected to the first battery cell, the first signal comprising first position information associated with the position of the voltage measurement device connected to the first battery cell.

6. The method of any one of claims 2 to 5, comprising:
obtaining, from a controller configured to selectively activate the electrical stimulus of the first battery cell, the unique ID associated with the first battery cell.

7. The method of claim 1, wherein each battery cell comprised within the battery system comprises a voltage measurement device, the voltage measurement device configured to measure a change in voltage experienced by the associated battery cell when a stimulus is applied to the battery cell by an electrical stimulus device connected to the associated battery cell, the method further comprising:
receiving, from the electrical stimulus device when connected to the first battery cell, the first signal comprising first position information associated with the position of the electrical stimulus device connected to the first battery cell, the first position information comprising information associated with a position of the electrical stimulus device relative to the first battery cell; and
determining the position of the first battery cell within the battery system, based on the first position information.

8. The method of claim 7, wherein the electrical stimulus device is configured to change the battery cell it is connected to by varying its position relative to the battery system.

9. The method of claim 7, wherein a plurality of electrical stimulus devices are positioned at different locations relative to the battery system, each electrical stimulus device connected to and positioned relative to a different one of the plurality of battery cells within the battery system, the method further comprising:
receiving, from the electrical stimulus device connected to the first battery cell, the first signal comprising first position information associated with the position of the electrical stimulus device connected to the first battery cell.

10. The method of any one of claims 7 to 9, further comprising:
receiving a second signal associated with the first battery cell experiencing the change in voltage, the second signal enabling the unique ID of the first battery cell to be determined; or
receiving a second signal associated with the first battery cell experiencing the change in voltage, the second signal comprising the unique ID of the first battery cell.

11. The method of claim 10, wherein the second signal is received from the first battery cell; and optionally
wherein each battery cell comprised within the battery system comprises a transmitter configured to transmit the second signal, and the method comprises:
receiving the second signal transmitted from the first battery cell.

12. The method of any preceding claim, wherein the electrical stimulus comprises:
an electrical load having an active state in which the electrical load draws current from the associated battery cell it is connected to, and an inactive state in which current is not drawn from the associated battery cell.

13. A processor for determining a position of a battery cell within a battery system comprising a plurality of battery cells, each battery cell having a unique identifier, ID, and each battery cell configured to experience a change in voltage when an electrical stimulus is applied to the battery cell, the processor being configured to carry out the method of any one of claims 1 to 12.

14. A method of determining a position of a battery cell within a battery system comprising a plurality of battery cells, each battery cell having a unique identifier, ID, and each battery cell comprising a processing device configured to emit an activation signal, the battery system being assembled in accordance with a predefined assembly sequence, and the method comprising:
receiving an activation signal associated with each one of the plurality of battery cells comprised within the battery system, each activation signal enabling the unique ID of the associated battery cell to be obtained;
associating a time coordinate with each received activation signal;
determining an activation sequence defining an order in which the processing devices associated with the plurality of battery cells are activated based on the time coordinate associated with each received activation signal and the unique ID associated with each battery cell; and
determining the position of each battery cell based on the activation sequence and the predefined assembly sequence.

15. The method of claim 14, wherein the predefined assembly sequence defines the physical order in which the plurality of battery cells are positioned within the battery system, the method further comprising:
determining the position of each battery cell by associating the activation sequence with the physical order in which the plurality of battery cells are positioned within the battery system.

16. The method of claim 15, wherein the predefined assembly sequence defines the physical order in which a different processing device is affixed to each battery cell within the battery system, the method further comprising:
determining the position of each battery cell by associating the activation sequence with the physical order in which a different processing device is affixed to each battery cell within the battery system.

17. The method of any one of claims 14 to 16, wherein the processing device is configured to emit the activation signal when the processing device first activates during assembly of the battery system, the method further comprising:
determining a time of receipt associated with each received activation signal; and
determining the activation sequence based on the time of receipt associated with each received activation signal and the unique ID associated with each battery cell.

18. The method of claim 17, further comprising:
determining the activation sequence by determining a chronological order of receipt of the activation signals; and
determining the position of each battery cell based on the chronological order of receipt of the activation signals and the predefined assembly sequence.

19. The method of any one of claims 14 to 16, wherein each processing device comprises a clock configured to begin measuring time when the processing device first activates during assembly of the battery system, the method further comprising:
receiving the time coordinate, wherein a different time coordinate is associated with each processing device, the time coordinate being indicative of a time lapse occurring between first activation of the associated processing device and transmission of the activation signal associated with each one of the plurality of battery cells;
determining a time difference between the time coordinates associated with each received activation signal; and
determining the activation sequence defining the order in which the processing devices associated with the plurality of battery cells first activate based on the determined time difference between the time coordinates associated with each received activation signal.

20. The method of claim 19, further comprising:
determining the activation sequence by determining a chronological order in which each processing device first activates during assembly of the battery system based on the determined time difference between the time coordinates associated with each received activation signal; and
determining the position of each battery cell based on the chronological order in which each processing device first activates and the predefined assembly sequence.

21. The method of claim 19 or 20, wherein the activation signals associated with the plurality of battery cells comprised within the battery system are received after the battery system is assembled.

22. The method of any one of claims 19 to 21, wherein the activation signals associated with the plurality of battery cells comprised within the battery system, are received in a single modulated transmission, the method further comprising:
demodulating the received modulated transmission to recover the activation signal associated with each one of the plurality of battery cells comprised within the battery system.

23. The method of any one of claims 14 to 22, wherein the activation signal comprises information enabling the unique ID of the associated battery cell to be determined, the method further comprising:
determining the unique ID of the battery cell from the information comprised in the associated activation signal; or
wherein the activation signal comprises the unique ID of the associated battery cell, the method further comprising:
obtaining the unique ID of the battery cell from the associated activation signal.

24. The method of any one of claims 14 to 23, wherein the unique ID associated with each battery cell is predetermined.

25. The method of any one of claims 14 to 24, wherein the activation signal is a short-range communication signal; and optionally
wherein the short-range communication signal is a near-field communication, NFC, signal having a transmission range of less than or equal to five centimetres.

26. A processor for determining a position of a battery cell within a battery system comprising a plurality of battery cells, each battery cell having a unique identifier, ID, and each battery cell comprising a processing device configured to emit an activation signal, the battery system being assembled in accordance with a predefined assembly sequence, the processor being configured to carry out the method of any one of claims 14 to 25.
